## Europäisches Patentamt
## European Patent Office
## Office européen des brevets

(19)

(11) Veröffentlichungsnummer : **0 180 730**
**B1**

(12) **EUROPÄISCHE PATENTSCHRIFT**

(45) Veröffentlichungstag der Patentschrift :
17.05.89

(51) Int. Cl.⁴ : **H 05 K 7/20**, H 01 L 23/36

(21) Anmeldenummer : 85110660.9

(22) Anmeldetag : 24.08.85

(54) Anordnung zur Spannungskompensation und Wärmeabführung an einem elektronischen Bauelement.

(30) Priorität : 31.10.84 CH 5203/84

(43) Veröffentlichungstag der Anmeldung :
14.05.86 Patentblatt 86/20

(45) Bekanntmachung des Hinweises auf die Patenterteilung : 17.05.89 Patentblatt 89/20

(84) Benannte Vertragsstaaten :
CH DE FR GB IT LI NL SE

(56) Entgegenhaltungen :
EP—A— 0 129 966
DE—A— 3 237 878
US—A— 4 046 442
PATENTS ABSTRACTS OF JAPAN, Band 7, Nr. 208 (E-
198) [1353], 14. September 1983, Seite 121 E 198 & JP -
A - 58 105 556

(73) Patentinhaber : CONTRAVES AG
Schaffhauserstrasse 580
CH-8052 Zürich (CH)

(72) Erfinder : Elsener, Josef
Anton Higistrasse 8
CH-8046 Zürich (CH)

**Beschreibung**

Die Erfindung betrifft eine Anordnung für Lötverbindungen von handelsüblichen Halbleiterbauelementen mit einem über einen Bolzen ein Kühlelement kontaktierendes Wärmeübertragungsteil.

Zum Abführen der Verlustwärme eines auf einer Leiterplatte montierten Halbleiterbausteins ist aus der DE-A 32 37 878 eine Anordnung bekannt, bei welcher an jedem Halbleiterbaustein ein mit einem Bund versehener Gewindebolzen befestigt und der Gewindebolzen mit einer Mutter an der Leiterplatte angeschraubt ist. Zur Erreichung der Wärmeableitung ist der Gewindebolzen mittels einer weiteren Schraube an eine als Kühlplatte vorgesehene Grundplatte des Aufnahme-Gehäuses angepresst und gehalten.

Bei den bekannten, modernen Halbleiteranordnungen besteht nicht ausschliesslich das Problem der Wärmeabfuhr sondern auch das Problem von Unterbrüchen, die aufgrund unterschiedlicher Ausdehnungskoeffizienten des eigentlichen Trägerelements in bezug zu dem einzelnen Halbleiterbaustein an den elektrischen Verbindungen (Lötstellen) entstehen können.

Eine andere Möglichkeit der Wärmeabfuhr vom Halbleiterelement durch ein Wärmeübertragungsteil zum Kühlelement ist in der US-A-4,046,442 beschrieben. Da es sich um einen steckbaren Baustein mit lötfreien Verbindungen (mit ihren bekannten Vor- und Nachteilen) handelt, ist der Ausdehnungsausgleich nicht Teil der Aufgabe; Lötverbindungen sind nicht vorgesehen. Überdies bedingt die Lösung die Herstellung nicht handelsüblicher Halbleiterbausteine.

Der Erfindung liegt nun die Aufgabe zugrunde, eine Anordnung der eingangs genannten Art derart auszubilden, dass einerseits ein Ausdehnungsausgleich im Bereich der elektrischen Verbindungen (Lötstellen) und andererseits eine erhöhte Wärmeabstrahlung bewirkt wird.

Diese Aufgabe wird durch die im kennzeichnenden Teil des Patentanspruches 1 genannten Merkmale gelöst.

Weitere Merkmale der Erfindung ergeben sich aus den Patentansprüchen und der folgenden Beschreibung in Verbindung mit der Zeichnung.

Die Erfindung wird nachstehend anhand der Zeichnung näher beschrieben. Es zeigt:

Fig. 1 eine schematisch und in Draufsicht dargestellte Halbleiteranordnung,

Fig. 2 eine in grösserem Massstab und in Schnittansicht gemäss der Linie II-II in Fig. 1 dargestellte erste Ausführungsform der Erfindung,

Fig. 3 eine Variante der elektrischen Verbindung für die erfindungsgemässe Halbleiteranordnung,

Fig. 4 eine in Schnittansicht dargestellte zweite Ausführungsform der Halbleiteranordnung, und

Fig. 5 eine in Schnittansicht dargestellte dritte Ausführungsform der Halbleiteranordnung.

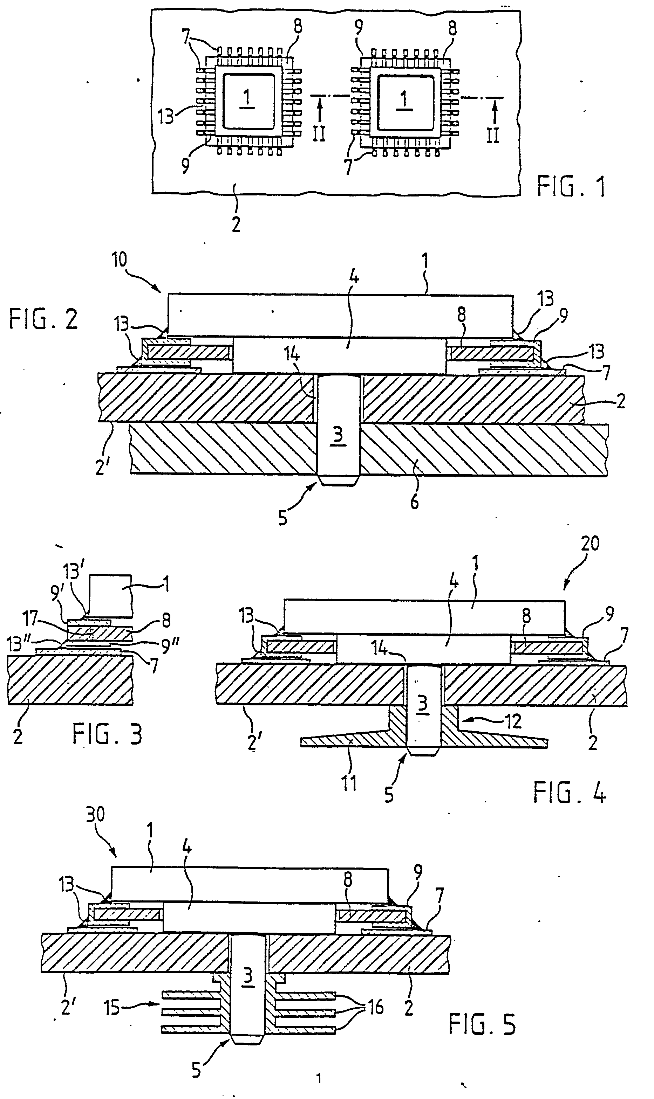

In Fig. 1 ist in Draufsicht eine mit 2 bezeichnete Leiterplatte dargestellt, auf welcher eine Vielzahl (in Fig. 1 sind nur zwei dargestellt) Halbleiterbausteine 1 (Chips) angeordnet und mit elektrischen Kontakten 7 (Bondpads) verlötet sind. Die mittels der Kontakte 7 miteinander elektrisch wirkverbundenen Teile 1 und 2 bilden einen integrierten Schaltkreis.

Fig. 2 zeigt in Schnittansicht und in grösserem Massstab eine erste Ausführungsform einer mit 10 bezeichneten Halbleiteranordnung und man erkennt den im wesentlichen durch eine Scheibe 4 im Abstand zu der Leiterplatte 2 angeordneten Halbleiterbaustein 1. An der Scheibe 4 ist ein Bolzen 3 angeordnet, welcher eine in der Leiterplatte 2 vorgesehene Bohrung 14 durchdringt. Die den Halbleiterbaustein 1 wärmeleitend kontaktierende und als erstes Kühlteil ausgebildete Scheibe 4 und der Bolzen 3 bilden zusammen ein mit 5 bezeichnetes Wärmeübertragungsteil. Die elektrische Verbindung des Halbleiterbauteils 1 mit der Leiterplatte 2 wird durch die mit 13 bezeichneten Lötverbindungen der auf der Leiterplatte 2 vorgesehenen Kontakte 7 mit entsprechend stirnseitig zugeordneten Verbindungsleitern 9 erreicht. Der einzelne Verbindungsleiter 9 ist zur Aufnahme einer Zwischenlage 8 [-förmig ausgebildet. Die Zwischenlage 8 ist entsprechend dem Umriss des wärmeabgebenden Halbleiterbausteins 1 ausgebildet und besteht vorzugsweise aus elastomeren Werkstoff. Zur Erreichung einer optimalen Wärmeableitung ist bei der ersten Ausführungsform an der Unterseite 2' der Leiterplatte 2 eine mit 6 bezeichnete Platte angeordnet, welche mit nicht dargestellten Mitteln an dem Bolzen 3 befestigt ist.

Fig. 4 zeigt die zweite Ausführungsform einer mit 20 bezeichneten Halbleiteranordnung, welche sich von der vorstehend beschriebenen Halbleiteranordnung 10 im wesentlichen dadurch unterscheidet, dass an der Unterseite 2' der Leiterplatte 2 ein mit nicht dargestellten Mitteln an dem Bolzen 3 befestigtes Kühlelement 12 angeordnet ist. Das Kühlelement 12 ist mit einer im Abstand zur Leiterplatte 2 angeordneten, grossflächigen Kühlscheibe 11 versehen.

Fig. 5 zeigt die dritte Ausführungsform einer mit 30 bezeichneten Halbleiteranordnung, welche sich von den Halbleiteranordnungen 10 und 20 dadurch unterscheidet, dass an der Unterseite 2' der Leiterplatte 2 ein mit nicht dargestellten Mitteln am Bolzen 3 befestigtes Kühlelement 15 angeordnet ist, welches mehrere, im Abstand zueinander angeordnete Kühlscheiben 16 aufweist.

In Fig. 3 ist eine im Ausschnitt dargestellte Variante der elektrischen Verbindung für die vorstehend beschriebenen Halbleiteranordnungen 10, 20 oder 30 dargestellt und man erkennt den Halbleiterbaustein 1, die Leiterplatte 2, die auf der Leiterplatte 2 vorgesehenen Kontakte 7 sowie die Zwischenlage 8. Bei dieser Variante umfasst der einzelne, den elektrischen Kontakt zwischen dem Halbleiterbaustein 1 und der Leiterplatte 2 herstellende Verbindungsleiter ein oberes und ein unteres Leiterteil 9′, 9″. Das einzelne Leiterteil 9′ ist mittels der Lötstelle 13′ mit dem Halbleiterbaustein 1 und das einzelne Leiterteil 9″ mittels der Lötstelle 13″ mit dem jeweils zugeordneten Kontakt 7 der Leiterplatte 2 elektrisch verbunden. Die beiden Leiterteile 9′,9″ sind durch eine die Zwischenlage 8 durchdringende Kontaktierung 17 elektrisch miteinander wirkverbunden.

Die zwischen dem einzelnen Halbleiterbaustein 1 und der Leiterplatte 2 angeordnete Zwischenlage 8 ist beispielsweise rahmenartig oder kreisringförmig ausgebildet und kann mit den einzelnen Leiterteilen 9 oder 9′, 9″ als eine Baueinheit ausgebildet sein. Die Zwischenlage 8 ist aus elastomerem, vorzugsweise aus PTFE Werkstoff hergestellt.

Bei den erfindungsgemässen Halbleiteranordnungen 10, 20 oder 30 wird zunächst das Wärmeübertragungsteil 5 mit dem Bolzen 3 in die Bohrung 14 der Leiterplatte 2 eingeführt und mit der Platte 6 oder dem Kühlelement 12 beziehungsweise 15 durch Aufpressen verbunden. Die Teile 5, 6, 12 und 15 können jedoch auch mit geeigneten Mitteln lösbar miteinander verbunden sein. Anschliessend wird die vorzugsweise mit den Verbindungsleitern 9, 9′, 9″ eine Einheit bildende Zwischenlage 8 auf den Kontakten 7 der Leiterplatte 2 plaziert und verlötet. Bei dem Lötvorgang kann gleichzeitig der Halbleiterbaustein 1 aufgelötet werden. Die als Kühlelement vorgesehenen Teile 5, 6, 12 und 15 werden vorzugsweise von einer nicht dargestellten Ventilation gekühlt.

**Patentansprüche**

1. Anordnung für Lötverbindung von Halbleiterbauelementen mit einem über einen Bolzen ein Kühlelement kontaktierendes Wärmeübertragungsteil, gekennzeichnet durch eine an den Kontaktreihen (13) des Halbleiterbauelements (1) entlang geführte Zwischenlage (8) zwischen Bauelement (1) und Leiterplatte (2) mit daran angeordneten elektrischen Kontakten (9), über welche die Lötverbindungen (13) von den Kontakten des Halbleiterbauelements zu den Leiterbahnen (7) der Leiterplatte (2) geführt sind, wobei das Wärmeübertragungsteil (3, 4) auf der Halbleiter-Bauteilseite angeordnet ist, auf welcher die Zwischenlage (8) geführt ist.

2. Anordnung nach Anspruch 1, dadurch gekennzeichnet, dass die Zwischenlage (8) rahmenartig oder kreisringförmig ausgebildet und mit den am Umfang verteilt angeordneten Verbindungsleitern (9, 9′, 9″) als Baueinheit auf der Leiterplatte (2) plaziert und mit den Kontakten (7) sowie dem Halbleiterbaustein (1) elektrisch wirkverbunden ist.

3. Anordnung nach Anspruch 1, dadurch gekennzeichnet, dass die Verbindungsleiter zur Aufnahme der Zwischenlage (8) im wesentlichen [-förmig ausgebildet und als Abstandhalter zwischen dem Halbleiterbaustein (1) und der Leiterplatte (2) angeordnet sind.

4. Anordnung nach Anspruch 1, dadurch gekennzeichnet, dass das mit dem Bolzen (3) des Wärmeübertragungsteils (5) in Wirkverbindung stehende Kühlelement (12, 15) ein oder mehrere im Abstand zueinander angeordnete grossflächige Kühlscheiben (11, 16) aufweist.

5. Anordnung nach Anspruch 1, dadurch gekennzeichnet, dass die Zwischenlage (8) aus PTFE-Werkstoff hergestellt ist.

**Claims**

1. Arrangement for the soldered connection of semiconductor components with a heat transfer part contacting a cooling element via a bolt, characterised by an intermediate layer (8) which extends along the rows of contacts (13) of the semiconductor module (1), between the component (1) and the printed circuit board (2), and which has electrical contacts (9) arranged thereon via which extend the soldered connections (13) from the contacts of the semiconductor component to the printed conductors (7) of the printed circuit board (2), the heat transfer part (3, 4) being arranged on the semiconductor component side on which extends the intermediate layer (8).

2. Arrangement according to claim 1, characterised in that the intermediate layer (8) is designed in the shape of a frame or a circular ring and with the connection conductors (9, 9′, 9″) distributed on the periphery is placed on the printed circuit board (2) as a modular unit and is actively connected electrically to the contacts (7) and to the semiconductor module (1).

3. Arrangement according to claim 1, characterised in that the connection conductors are designed essentially in a [-shape to accommodate the intermediate layer (8) and are arranged as spacers between the semiconductor module (1) and the printed circuit board (2).

4. Arrangement according to claim 1, characterised in that the cooling element (12, 15) in active connection with the bolt (3) of the heat transfer part (5) has one or more large-area cooling discs (11, 16) arranged mutually spaced apart.

5. Arrangement according to claim 1, characterised in that the intermediate layer (8) is made of PTFE material.

**Revendications**

1. Dispositif pour souder des composants semi-conducteurs sur une pièce de transmission de chaleur en contact avec un élément de refroidissement par l'intermédiaire d'un goujon, dispositif caractérisé par une couche intermédiaire (8) guidée le long des rangées de contacts (13) du composant semi-conducteur (1), entre le composant et la plaque conductrice (2) et les contacts électriques (9) qu'elle porte et par lesquels les liaisons soudées (13) des contacts du composant semi-conducteur vont vers les chemins conducteurs (7) de la plaque conductrice (2), la pièce de transmission de chaleur (3, 4) étant montée sur le côté du composant semi-conducteur, là où se trouve la couche intercalaire (8).

2. Dispositif selon la revendication 1, caractérisé en ce que la couche intercalaire (8) est en forme de châssis ou de rondelle et est placée par les conducteurs de liaison (9, 9', 9") répartis à la périphérie, comme pièces sur la plaque conductrice (2') et est reliée électriquement aux contacts (7), ainsi qu'au composant semi-conducteur (1).

3. Dispositif selon la revendication 1, caractérisé en ce que le conducteur de liaison est réalisé en forme de C, pour recevoir la couche intermédiaire (8) et est placé comme dispositif d'écartement entre le composant semi-conducteur (1) et la plaque semi-conductrice (2).

4. Dispositif selon la revendication 1, caractérisé en ce que l'élément de refroidissement (12, 15) coopérant avec le goujon (3) de l'élément de transmission de chaleur (5) comporte un ou plusieurs disques de refroidissement (11, 16) de grande surface distant l'un de l'autre.

5. Dispositif selon la revendication 1, caractérisé en ce que la couche intercalaire (8) est en un matériau à base de PTFE.

FIG. 1

FIG. 2

FIG. 3

FIG. 4

FIG. 5